# FASCICULE DE BREVET EUROPEEN

(11) **EP 0 611 198 B1**
(45) Date de publication et mention de la délivrance du brevet: **18.12.1996**
(21) Numéro de dépôt: 94400252.6
(22) Date de dépôt: 07.02.1994
(51) Int. Cl.: H01L 23/473, H01L 25/11

(54) **Dispositif de refroidissement de composants électriques de puissance**
Kühlungsanordnung für elektrische Leistungsbauteile
Cooling device for electrical power components

(30) Priorité: 10.02.1993 FR 9301459
(43) Date de publication de la demande: 17.08.1994
(73) Titulaire: GEC ALSTHOM TRANSPORT SA, 75016 Paris (FR)
(72) Inventeur: Dubelloy, Jean-Luc, F-69500 Bron (FR)
(74) Mandataire: Fournier, Michel

(56) Documents cités:
- EP-A- 0 144 579
- CH-A- 677 293
- US-A- 4 183 042

## Description

La présente invention concerne un dispositif de refroidissement de composants électriques de puissance utilisable en particulier pour des éléments semi-conducteurs.

Il est courant de refroidir des composants électriques de puissance et sous tension élevée grâce à la circulation d'un fluide caloporteur. Plusieurs solutions ont été proposées.

Le fluide caloporteur peut être de l'eau qui a pour avantage d'être bon marché et non polluant. Il faut dans ce cas prévoir une isolation électrique entre l'eau de refroidissement et les parties conductrices du composant à refroidir. Ainsi le document DE 4 017 749 divulgue un dispositif de refroidissement pour composant semi-conducteur dont les contacts électriques se présentent sous la forme de deux surfaces parallèles et opposées. Les composants étant destinés à être superposés, on empile successivement une première connexion électrique, un premier composant, une seconde connexion électrique, un corps isolant électrique et bon conducteur thermique dans lequel circule de l'eau, une nouvelle première connexion électrique, etc.... Cette solution s'avère particulièrement encombrante. En outre les matériaux isolants électriques et bon conducteurs thermiques sont quand même moins efficaces dans les échanges thermiques qu'un métal bon conducteur électrique tel que le cuivre.

On connaît également des dispositifs de refroidissement direct où un corps conducteur thermique et électrique est disposé directement sur la connexion électrique. Ce corps conducteur est relié à des tubes isolants permettant la circulation d'un fluide diélectrique de refroidissement dans le corps. Le fluide diélectrique peut être de l'huile ou, si l'on préfère un fluide bon marché et non polluant, de l'eau désionisée. L'huile présente en outre de mauvaises performances thermiques. Quant à l'eau désionisée, elle nécessite un système de traitement encombrant et coûteux.

Une autre solution consiste à effectuer le refroidissement par interposition de plaques isolantes encapsulées. Dans le cas de la superposition de composants semi-conducteurs du type de ceux décrits plus hauts, on effectue l'empilement de la manière suivante: composant, connexion électrique, une première masselotte en cuivre, une plaque d'isolant électrique et conducteur de la chaleur, une seconde masselotte en cuivre, un corps refroidisseur métallique dans lequel circule un fluide tel que de l'eau, puis les mêmes éléments pris en sens inverse: les deux masselottes séparées par la plaque d'isolant, la connexion électrique et le composant. Pour augmenter le cheminement des lignes de champ électrique, il est nécessaire d'encapsuler la plaque isolante entre les deux masselottes adjacentes. Cette solution conduit à un dispositif très encombrant.

Ces différentes solutions connues présentent donc toutes des inconvénients que la présente invention permet de résoudre. Dans ce but on propose un dispositif intégrant en un seul ensemble au moins une connexion électrique, une plaque d'isolation par connexion et un corps de refroidissement métallique fonctionnant avec de l'eau non désionisée.

L'invention a donc pour objet un dispositif de refroidissement pour composant électrique de puissance disposant d'électrodes, comprenant un radiateur comportant un circuit permettant la circulation d'un fluide de refroidissement et une première face d'échange thermique en contact thermique avec le composant à refroidir, caractérisé en ce que le dispositif comporte en outre une plaque en matériau isolant électrique et bon conducteur thermique comprise entre ladite première face du radiateur et une première face d'une connexion électrique dont la deuxième face est destinée à être en contact thermique et électrique avec l'une des électrodes du composant, le dispositif comportant des moyens assurant la liaison mécanique entre le radiateur et ladite connexion électrique de manière que le dispositif de refroidissement forme un ensemble compact.

Les moyens de liaison mécanique peuvent comprendre un isolateur électrique disposé entre ladite connexion et le radiateur, fixé d'une part à cette connexion et d'autre part au radiateur, et délimitant entre le radiateur et cette connexion une zone protégée des pollutions.

La liaison mécanique peut être assurée par de la résine remplissant ladite zone protégée.

Elle peut être assurée d'une part par un clinquant reliant le radiateur à l'isolateur et d'autre part par fixation de l'isolateur sur ladite connexion.

Le radiateur ne possédant qu'une seule face d'échange thermique, il peut être constitué de deux parties, une première partie dont une face constitue ladite face d'échange thermique et dont une autre face comporte une rainure destinée à la circulation du fluide de refroidissement, et une seconde partie dont une face recouvre la seconde face de la première partie, cette seconde partie possédant des orifices d'entrée et de sortie du fluide de refroidissement dans le radiateur, un conduit d'amenée du fluide de refroidissement depuis l'orifice d'entrée jusqu'à l'entrée de ladite rainure et un conduit d'évacuation du fluide de refroidissement depuis la sortie de ladite rainure jusqu'à l'orifice de sortie.

Le radiateur possédant deux faces d'échange thermique correspondant à deux composants à refroidir, il peut être constitué de trois parties, une première partie dont une première face constitue l'une desdites face d'échange thermique et dont une seconde face comporte une première rainure destinée à la circulation du fluide de refroidissement, une seconde partie dont une première face constitue l'autre face d'échange thermique et dont une seconde face comporte une seconde rainure destinée à la circulation du fluide de refroidissement, une troisième partie dont une face recouvre la seconde face de la première partie et dont une autre face recouvre la seconde face de la seconde partie, cette troisième partie possédant des orifices d'entrée et de sortie du fluide de refroidissement dans le radiateur, un conduit d'amenée du fluide de refroidissement depuis l'orifice d'entrée jusqu'à l'entrée de la première rainure, un conduit de circulation du fluide entre la sortie de la première rainure jusqu'à l'entrée de la seconde rainure, un conduit d'évacuation du fluide de refroidissement depuis la sortie de la seconde rainure jusqu'à l'orifice de sortie.

Le circuit permettant la circulation du fluide de refroidissement peut avoir, pour une face d'échange thermique ou pour chaque face d'échange thermique, la forme d'une spirale.

L'invention sera mieux comprise et d'autres avantages et particularités apparaîtront à la lecture de la description qui va suivre, donnée à titre non limitatif, accompagnée des dessins annexés parmi lesquels:
- la figure 1 est une vue en coupe d'un dispositif de refroidissement selon l'invention et destiné au refroidissement de deux composants électriques de puissance,
- la figure 2 est une vue du radiateur du dispositif de refroidissement selon la coupe II-II de la figure 1,
- la figure 3 est une vue du radiateur du dispositif de refroidissement selon la coupe III-III de la figure 1,
- la figure 4 est une vue en coupe d'un dispositif de refroidissement selon l'invention et destiné au refroidissement d'un seul composant électrique de puissance.

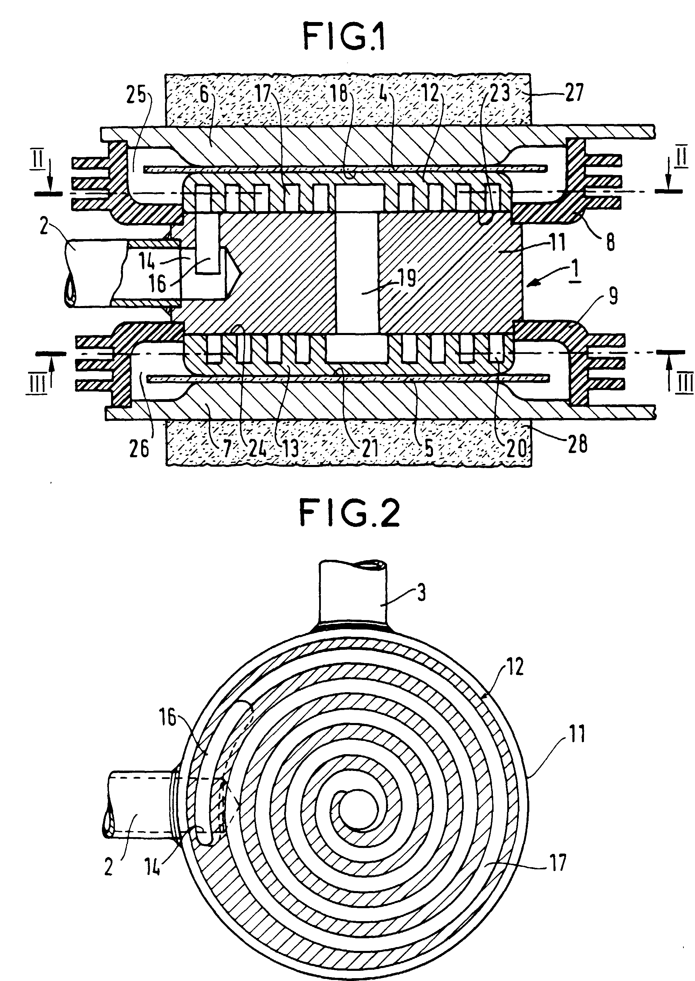

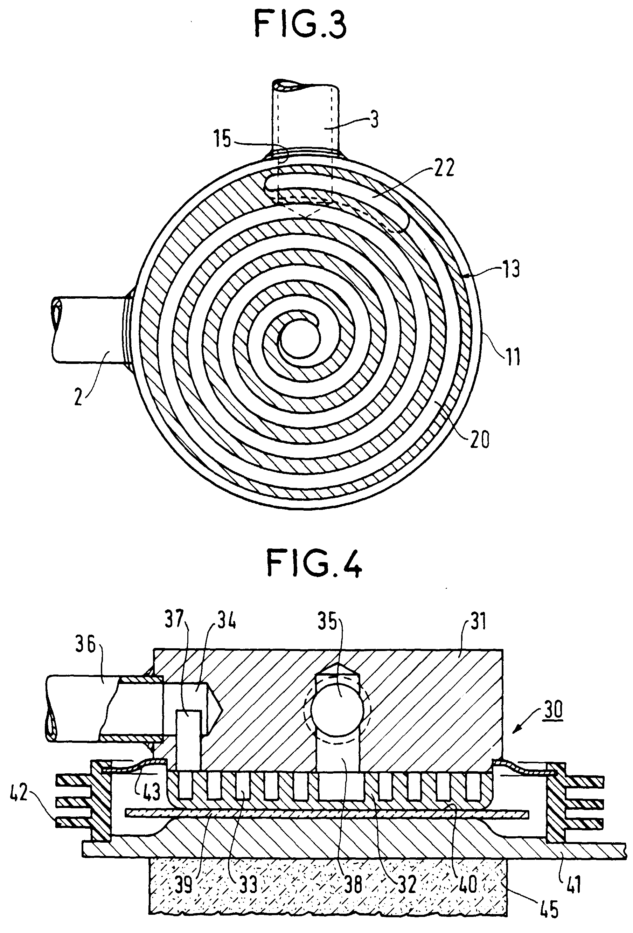

Le dispositif représenté à la figure 1 possède deux faces d'échange thermique opposées. Il comprend un radiateur 1 constitué à partir de trois pièces : un corps central 11, une première pièce d'échange thermique 12 et une seconde pièce d'échange thermique 13. Le radiateur permet la circulation d'un fluide de refroidissement qui lui est par exemple amené par le conduit 2 aboutissant à l'orifice d'entrée 14 du radiateur et évacué par le conduit 3 aboutissant à l'orifice de sortie 15 (voir les figures 2 et 3).

Depuis l'orifice d'entrée 14 jusqu'à l'orifice de sortie 15, le circuit de refroidissement est constitué: d'un conduit 16 reliant l'orifice d'entrée 14 à des canaux 17 situés à proximité immédiate de la face d'échange thermique 18, d'un conduit 19 reliant les canaux 17 aux canaux 20 situés à proximité immédiate de la face d'échange thermique 21, d'un conduit 22 (voir la figure 3) reliant les canaux 20 à l'orifice de sortie 15.

Les canaux 17 et 20 sont, dans l'exemple de réalisation représenté, en forme de spirale comme le montrent bien les figures 2 et 3. Ces canaux sont avantageusement réalisés de la manière suivante. On usine des rainures en spirale à partir des face 23 et 24 des pièces 12 et 13, ces faces étant opposées respectivement aux faces d'échange thermique 18 et 21. Une fois les trois parties 11, 12 et 13 superposées comme le montre la figure 1, les rainures sont recouvertes et le fluide de refroidissement ne peut que circuler en spirale.

Les pièces 12 et 13 sont réalisées en un même métal bon conducteur thermique comme le cuivre. La pièce 11 peut aussi être réalisée en cuivre. Leur assemblage peut être avantageusement obtenu par brasage des pièces 12 et 13 sur la pièce 11.

Les conduits 2 et 3 peuvent être fixés au bloc 11 par brasage ou vissage.

Pour obtenir un bon transfert du fluide de refroidissement à l'entrée des canaux 17 ou à la sortie des canaux 20, il est avantageux de donner aux conduits 16 et 22 une forme allongée s'adaptant bien à la forme en spirale des rainures.

Le dispositif de refroidissement comprend aussi des plaques 4 et 5 reposant respectivement sur les faces d'échange thermique 18 et 21. Ces plaques 4 et 5 sont en un matériau bon isolant électrique et bon conducteur thermique, par exemple en céramique.

Les plaques 4 et 5 supportent respectivement les connexions électriques 6 et 7, par exemple en cuivre. Chaque plaque isolante présente avec ses pièces d'échange thermique et connexion électrique correspondantes de grandes surfaces communes pour faciliter la transmission de la chaleur engendrée par les composants électriques. Les connexions électriques 6 et 7 présentent également de grandes surfaces de contact, électrique et thermique, avec les composants 27 et 28.

Les formes données aux connexions électriques, aux plaques isolantes et aux pièces d'échange thermique permettent de pallier aux influences des champs électriques. Ainsi, en quittant leur surface commune avec une plaque isolante, la connexion électrique et la pièce d'échange thermique ont des formes arrondies pour limiter les champs électriques. Pour la même raison, les plaques isolantes débordent suffisamment des faces d'échange thermique.

Le dispositif comprend enfin des isolateurs 8 et 9, par exemple en matériau polymère, correspondant respectivement aux faces d'échange thermique 18 et 21. Ces isolateurs permettent de protéger des zones annulaires 25, 26 particulièrement sensibles d'un point de vue électrique aux pollutions. Ces zones peuvent être soit laissées remplies d'air propre, soit remplies d'un matériau diélectrique tel qu'un gel ou une résine.

Il convient d'assurer une bonne étanchéité des zones protégées 25 et 26. En remplissant ces zones de résine on obtient un ensemble compact regroupant le radiateur 1, les plaques isolantes 4 et 5 et les connexions électriques 6 et 7. Cet ensemble peut être avantageusement monté en assemblant les différents constituants du dispositif, pressés avec l'effort de serrage correspondant au besoin des semi-conducteurs (par exemple 3,5 tonnes pour un composant de 75mm de diamètre). Ensuite on injecte la résine par des orifices prévus dans les isolateurs 8 et 9. Après polymérisation de la résine, on obtient un dispositif solidaire prêt à être utilisé dans une pile de semi-conducteurs.

Il faut remarquer que les connexions électriques 6 et 7 peuvent être orientées identiquement ou de manière décalée. Dans certains cas, ces connexions peuvent être reliées électriquement entre elles.

Un avantage important de la présente invention est la réduction de la distance séparant deux composants électriques à refroidir. Ainsi, il est courant d'avoir selon l'art connu décrit plus haut (interposition de plaque isolante encapsulée entre connexion et corps refroidisseur), pour des semi-conducteurs sous une tension de 4,5 kV, une distance de 80 mm entre deux composants successifs dans un empilement, pour une puissance dissipée de 1500 W. Dans les mêmes conditions (26 mm d'épaisseur de semi-conducteurs, sous 4,5 kV), le dispositif selon l'invention peut être réduit à 50 mm d'épaisseur et permet de dissiper une puissance de 2200 W.

Le dispositif représenté à la figure 4 est utilisable pour le refroidissement d'un seul composant, par exemple pour le composant 45 situé en extrémité d'une pile de composant. Il comprend un radiateur 30 en deux parties: un corps 31 et une pièce d'échange thermique 32 brasée sur le corps 30. Une rainure 33 est usinée dans la pièce 32 pour constituer les canaux de refroidissement. Comme précédemment on lui a donné une forme en spirale.

Le corps 31 comprend un orifice d'entrée 34 du fluide de refroidissement et un orifice 35 de sortie de ce fluide. Ces orifices reçoivent des conduits permettant l'amenée et l'évacuation du fluide. Seul le conduit d'amenée 36 est visible sur la figure 4. Un conduit 37 réunit l'orifice d'entrée 34 à l'entré de la rainure 33. Un conduit 38 réunit la sortie de la rainure 33 à l'orifice de sortie 35.

Une plaque 39 en céramique par exemple est disposée entre la face d'échange thermique 40 de la pièce 32 et la connexion électrique 41.

Le dispositif comporte également un isolateur 42 protégeant la zone électriquement sensible aux pollutions. Le maintien mécanique de l'ensemble du dispositif peut être assuré par fixation de l'isolateur 42 sur la connexion électrique 41 (par collage par exemple) et grâce au clinquant annulaire 43 encastré par un bord dans l'isolateur 42 et brasé, par l'autre bord, sur le corps 31.

Un autre moyen d'assurer le maintien de l'ensemble est de braser la plaque 39 sur la pièce 32 et sur la connexion électrique 41. Dans ce cas, la plaque en céramique 39 comporte des métallisations sur ses faces principales pour permettre le brasage.

Parmi les avantages de l'invention, on peut citer l'utilisation d'eau comme fluide de refroidissement qui peut comprendre un antigel (par exemple le glycol), l'absence de système de filtration du fluide de refroidissement. Les plaques isolantes peuvent être protégées des pollutions extérieures. Un autre avantage est constitué par l'intégration totale de la connexion électrique, du radiateur et de l'isolation électrique en un seul ensemble.

## Revendications

1. Dispositif de refroidissement pour composant électrique de puissance disposant d'électrodes, comprenant un radiateur (1) comportant un circuit permettant la circulation d'un fluide de refroidissement et une première face d'échange thermique (18, 40) en contact thermique avec le composant à refroidir, caractérisé en ce que le dispositif comporte en outre une plaque (4, 39) en matériau isolant électrique et bon conducteur thermique comprise entre ladite première face du radiateur et une première face d'une connexion électrique (6, 41) dont la deuxième face est destinée à être en contact thermique et électrique avec l'une des électrodes du composant, le dispositif comportant des moyens assurant la liaison mécanique entre le radiateur et ladite connexion électrique de manière que le dispositif de refroidissement forme un ensemble compact.

2. Dispositif selon la revendication 1, caractérisé en ce que les moyens de liaison mécanique comprennent un isolateur électrique (8, 42) disposé entre ladite connexion (6, 41) et le radiateur (1, 30), fixé d'une part à cette connexion et d'autre part au radiateur, et délimitant entre le radiateur et cette connexion une zone (25) protégée des pollutions.

3. Dispositif selon la revendication 2, caractérisé en ce que la liaison mécanique est assurée par de la résine remplissant ladite zone protégée (25).

4. Dispositif selon la revendication 2, caractérisé en ce que la liaison mécanique est assurée d'une part par un clinquant (43) reliant le radiateur (30) à l'isolateur (42) et d'autre part par fixation de l'isolateur sur ladite connexion (41).

5. Dispositif selon l'une quelconque des revendications 1 à 4, caractérisé en ce que, le radiateur (30) ne possédant qu'une seule face d'échange thermique (40), il est constitué de deux parties, une première partie (32) dont une face constitue ladite face d'échange thermique et dont une autre face comporte une rainure (33) destinée à la circulation du fluide de refroidissement, et une seconde partie (31) dont une face recouvre la seconde face de la première partie, cette seconde partie possédant des orifices d'entrée (34) et de sortie (35) du fluide de refroidissement dans le radiateur, un conduit d'amenée (37) du fluide de refroidissement depuis l'orifice d'entrée jusqu'à l'entrée de ladite rainure et un conduit d'évacuation (38) du fluide de refroidissement depuis la sortie de ladite rainure jusqu'à l'orifice de sortie.

6. Dispositif selon l'une quelconque des revendications 1 à 4, caractérisé en ce que, le radiateur possédant deux faces d'échange thermique (18, 21) correspondant à deux composants à refroidir, il est constitué de trois parties, une première partie (12) dont une première face constitue l'une desdites face d'échange thermique et dont une seconde face (23) comporte une première rainure (17) destinée à la circulation du fluide de refroidissement, une seconde partie (13) dont une première face (21) constitue l'autre face d'échange thermique et dont une seconde face (24) comporte une seconde rainure (20) destinée à la circulation du fluide de refroidissement, une troisième partie (11) dont une face recouvre la seconde face (23) de la première partie (12) et dont une autre face recouvre la seconde face (24) de la seconde partie (13), cette troisième partie possédant des orifices d'entrée (14) et de sortie (15) du fluide de refroidissement dans le radiateur, un conduit d'amenée (16) du fluide de refroidissement depuis l'orifice d'entrée (14) jusqu'à l'entrée de la première rainure (17), un conduit (19) de circulation du fluide entre la sortie de la première rainure (17) jusqu'à l'entrée de la seconde rainure (20), un conduit d'évacuation (22) du fluide de refroidissement depuis la sortie de la seconde rainure (20) jusqu'à l'orifice de sortie (15).

7. Dispositif selon l'une quelconque des revendications précédentes, caractérisé en ce que le circuit permettant la circulation du fluide de refroidissement a, pour une face d'échange thermique ou pour chaque face d'échange thermique, la forme d'une spirale.

## Patentansprüche

1. Kühlvorrichtung für ein Elektroden aufweisendes elektrisches Leistungsbauelement, die einen Kühler (1) mit einem Kreislauf, welcher den Umlauf eines Kühlfluids ermöglicht, und mit einer ersten Wärmetauscherfläche (18, 40) in Wärmekontakt mit dem zu kühlenden Bauelement enthält, dadurch gekennzeichnet, daß die Vorrichtung weiter eine Platte (4, 39) aus einem elektrisch isolierenden und gut wärmeleitenden Material aufweist, die zwischen der ersten Fläche des Kühlers und einer ersten Fläche eines elektrischen Anschlusses (6, 41) liegt, dessen zweite Fläche mit einer der Elektroden des Bauelements in thermischem und elektrischem Kontakt stehen soll, wobei die Vorrichtung Mittel aufweist, die die mechanische Verbindung zwischen dem Kühler und dem elektrischen Anschluß derart gewährleistet, daß die Kühlvorrichtung eine kompakte Einheit bildet.

2. Vorrichtung nach Anspruch 1, dadurch gekennzeichnet, daß die mechanischen Verbindungsmittel einen elektrischen Isolator (8, 42) aufweisen, der zwischen dem Anschluß (6, 41) und dem Kühler (1, 30) angeordnet und einerseits an diesem Anschluß und andererseits am Kühler befestigt ist und der zwischen dem Kühler und dem Anschluß eine vor Verunreinigungen geschützte Zone (25) begrenzt.

3. Vorrichtung nach Anspruch 2, dadurch gekennzeichnet, daß die mechanische Verbindung durch ein diese geschützte Zone (25) füllendes Harz gewährleistet wird.

4. Vorrichtung nach Anspruch 2, dadurch gekennzeichnet, daß die mechanische Verbindung einerseits durch eine Metallfolie (43), die den Kühler (30) mit dem Isolator (42) verbindet, und andererseits durch Befestigung des Isolators an dem Anschluß (41) gewährleistet wird.

5. Vorrichtung nach einem beliebigen der Ansprüche 1 bis 4, dadurch gekennzeichnet, daß der Kühler (30), wenn er nur eine Wärmetauscherfläche (40) aufweist, aus zwei Teilen besteht, nämlich einem ersten Teil (32), von dem eine Fläche die Wärmetauscherfläche bildet und von dem eine andere Fläche eine Rille (33) für den Umlauf des Kühlfluids aufweist, und einem zweiten Teil (31), von dem eine Fläche die zweite Fläche des ersten Teils bedeckt und der Einlaß- (34) und Auslaßöffnungen (35) für das Kühlfluid, eine Zufuhrleitung (37) für Kühlfluid von der Einlaßöffnung bis zum Eingang der Rille und eine Abfuhrleitung für Kühlfluid vom Ausgang der Rille bis zur Auslaßöffnung aufweist.

6. Vorrichtung nach einem beliebigen der Ansprüche 1 bis 4, dadurch gekennzeichnet, daß der Kühler, wenn er zwei Wärmetauscherflächen (18, 21) entsprechend zwei zu kühlenden Bauelementen aufweist, aus drei Teilen besteht, nämlich einem ersten Teil (12), von dem eine erste Fläche eine der Wärmetauscherflächen bildet und von dem eine zweite Fläche (23) eine erste Rille (17) für den Umlauf des Kühlfluids aufweist, einem zweiten Teil (13), von dem eine erste Fläche (21) die andere Wärmetauscherfläche bildet und von dem eine zweite Fläche (24) eine zweite Rille (20) für den Umlauf des Kühlfluids bildet, einem dritten Teil (11), von dem eine Fläche die zweite Fläche (23) des ersten Teils (12) bedeckt und von dem eine andere Fläche die zweite Fläche (24) des zweiten Teils (13) bedeckt und der Einlaß- (14) und Auslaßöffnungen (15) für das Kühlfluid, eine Zufuhrleitung (16) für Kühlfluid von der Einlaßöffnung (14) bis zum Eingang der ersten Rille (17), eine Leitung (19) für das Fluid zwischen dem Ausgang der ersten Rille (17) und dem Eingang der zweiten Rille (20), eine Abfuhrleitung (22) für das Kühlfluid vom Ausgang der zweiten Rille (20) bis zur Auslaßöffnung (15) aufweist.

7. Vorrichtung nach einem beliebigen der Ansprüche 1 bis 4, dadurch gekennzeichnet, daß der den Umlauf des Kühlfluids ermöglichende Kreislauf für eine Wärmetauscherfläche oder für jede Wärmetauscherfläche die Form einer Spirale aufweist.

## Claims

1. Cooling device for power electrical components having electrodes, the device comprising a heatsink (1) including a circuit in which a cooling fluid can flow and a first side (18, 40) for exchange of heat with and in thermal contact with the component to be cooled, characterised in that the device further comprises an electrically insulative and good heat conductor material plate (4, 39) between said first side of the heatsink and a first side of an electrical connection (6, 41) whose second side is adapted to make thermal and electrical contact with one electrode of the component, the device including means mechanically joining the heatsink and said electrical connection so that the cooling device forms a compact assembly.

2. Device according to claim 1 characterised in that the mechanical coupling means comprise an electrical insulator (8, 42) disposed between said connection (6, 41) and the heatsink (1, 30), fixed to said connection and to the heatsink and delimiting between the heatsink and said connection an area (25) protected from pollution.

3. Device according to claim 2 characterised in that the mechanical coupling is provided by resin filling said protected area (25).

4. Device according to claim 2 characterised in that the mechanical coupling is provided by a foil (43) joining the heatsink (30) to the insulator (42) and by fixing the insulator to said connection (41).

5. Device according to any one of claims 1 to 4 characterised in that the heatsink (30) has only one heat exchange side (40) and is in two parts, a first part (32) having a side constituting said heat exchange side and another side including a groove (33) in which cooling fluid can flow, and a second part (31) having one side covering the second side of the first part, said second part having cooling fluid inlet and outlet orifices (34, 35), a fluid inlet pipe (37) leading from the inlet orifice to an inlet of said groove and a fluid outlet pipe (38) leading from the outlet of said groove to the outlet orifice.

6. Device according to any one of claims 1 to 4 characterised in that the heatsink has two heat exchange sides (18, 21) corresponding to two components to be cooled and is in three parts, a first part (12) having a first side which constitutes one of said heat exchange sides and a second side (23) including a first groove (17) in which cooling fluid can flow, a second part (13) having a first side (21) which constitutes the other heat exchange side and a second side (24) including a second groove (20) in which cooling fluid can flow, and a third part (11) having one side covering the second side (23) of the first part (12) and another side covering the second side (24) of the second part (13), said third part having cooling fluid inlet and outlet orifices (14, 15), a cooling fluid inlet pipe (16) leading from the inlet orifice (14) to an inlet of the first groove (17), a fluid pipe (19) between an outlet of the first groove (17) and the inlet of the second groove (20), and a cooling fluid outlet pipe (22) leading from the outlet of the second groove (20) to the outlet orifice (15).

7. Device according to any one of the preceding claims characterised in that the cooling fluid circuit is spiral in shape on one heat exchange side or on each heat exchange side.
